Europäisches Patentamt

European Patent Office

Office européen des brevets

(11) Publication number : 0 554 123 A1

# EUROPEAN PATENT APPLICATION

(21) Application number : 93300699.1

(22) Date of filing : 29.01.93

(51) Int. Cl.⁵ : **H01L 21/90**, H01L 21/311

(30) Priority : **31.01.92 US 828735**

(43) Date of publication of application :
**04.08.93 Bulletin 93/31**

(84) Designated Contracting States :
**DE FR GB IT**

(71) Applicant : **SGS-THOMSON
MICROELECTRONICS, INC.
1310 Electronics Drive
Carrollton Texas 75006 (US)**

(72) Inventor : **Nguyen, Loi Ngoc
1724 Brighton Drive, Carrollton
Denton County, Texas 75007 (US)**

(74) Representative : **Palmer, Roger et al
PAGE, WHITE & FARRER 54 Doughty Street
London WC1N 2LS (GB)**

(54) **A method for forming a contact.**

(57)   A thin layer of material (16) is deposited over an interlevel dielectric (14), which may be a planarizing interlevel dielectric. The thin layer (16) is a material which can be etched highly selectively over the material used for the interlevel dielectric (14), and acts as a hard mask for the interlevel dielectric layer (14). A thin layer of resist (18) is formed over the hard mask layer (16) and used to pattern the hard mask layer (16). The hard mask layer (16) is then used as a pattern for etching contact vias (20) through the interlevel dielectric (14). After via (20) formation, underlying conductive regions (12), at the bottom of the contact vias (20), are protected during removal of the hard mask layer (16) by refilling the contact openings with a second resist layer (24). This technique provides improved resolution due to the thin photoresist layer which is used to define device features, while adequately protecting.

FIG. 6

EP 0 554 123 A1

The present invention relates generally to semiconductor integrated circuits, and more specifically to a method for forming a contact between layers of conductive structures.

As the sizes of integrated circuits continue to shrink, feature sizes obtainable on the chip are becoming limited by the physical properties of the photoresist materials used for masking. The light used to expose these photoresist materials is scattered, reflected, absorbed, and diffracted through the photoresist. The inability to prevent scattering of light beyond the edges of the mask openings limits the sizes of various features on the device, such as interlevel vias used for contacts. Depositing thinner resists improves the resolution of the photolithography, but thin resists do not provide protection for the underlying layers being masked.

Since the underlying topography on integrated circuit devices tends to be very uneven, layers of planarizing interlevel dielectric are typically used to improve the overall planarity of the device. However, such layers may be relatively thick over some portions of the circuit, requiring long etch times to ensure complete clearing of the vias between interconnect levels. The masking photoresist must be made thick enough to mask the interlevel dielectric layer for the entirety of the etch process. The thick photoresist layers needed to protect the underlying interlevel dielectric are incompatible with the use of thin layers to improve resolution.

Various techniques have been tried in order to improve the resolution of the photo lithography. One of these techniques, for example, provides a bi-level photoresist process, in which an upper resist level is exposed separately and used as a mask for an underlying resist level. Other techniques include the use a high numerical aperture and/or shorter wavelength stepper to improve resolution. This improvement is obtained at a higher equipment cost and a greatly decreased depth of focus.

It would be desirable to provide a technique for patterning integrated circuit device features, such as contact vias, which uses widely available photolithographic techniques while providing superior feature size resolution. It is extremely desirable for such a technique to be compatible with standard industry process flows.

Therefore, according to the present invention, a thin layer of material is deposited over an interlevel dielectric, which may be a planarizing interlevel dielectric. The thin layer is a material which can be etched highly selectively over the material used for the interlevel dielectric, and acts as a hard mask for the interlevel dielectric layer. A thin layer of resist is formed over the hard mask layer and used to pattern the hard mask layer. The hard mask layer is then used as a pattern for etching contact vias through the interlevel dielectric. After via formation, underlying conductive regions, at the bottom of the contact vias, are protected during removal of the hard mask layer by refilling the contact openings with a second resist layer. This technique provides improved resolution due to the thin photoresist layer which is used to define device features, while adequately protecting.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

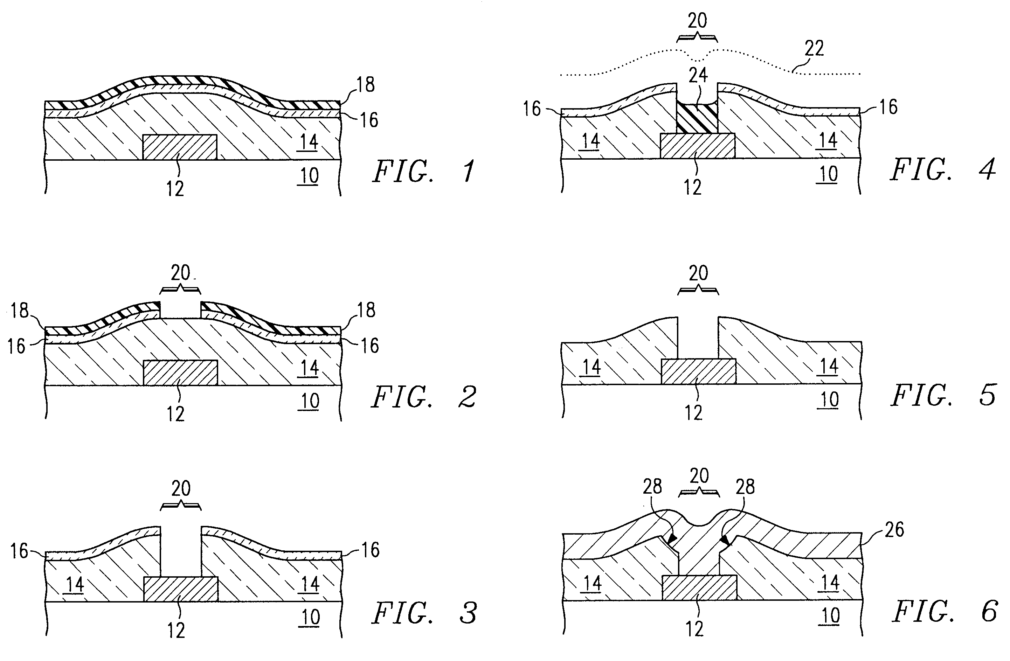

**Figures 1 - 6** illustrate the formation of a contact opening according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

In general, the resolution used in photo lithographic processing can be described using the following formula:

$$R = K$$

In this formula, the exposure wavelength and the numerical aperture are presumed fixed for a given piece of photolithographic equipment. The only way to improve resolution for a given system is to lower the factor K. Lower K factors can be obtained by draining the resist material, or by decreasing the thickness of the photoresist film which is exposed.

A technique for forming contact openings using thin photoresist films is illustrated in **Figures 1 - 6.** Referring to **Figure 1**, active integrated circuit devices (not shown) are formed in a semiconductor substrate **10**. Although the region **10** is described herein as a substrate, it will be appreciated that it can represent any number of underlying interconnect layers in addition to the actual substrate containing active devices. A conductive element **12** overlies the substrate **10**, and is typically formed from polycrystalline silicon which has been patterned to define an interconnect layer. Conductive element **12** is typically silicided with a refractory metal, as known in the art, in order to improve its conductivity.

A planarizing layer of interlevel dielectric **14** is formed over the conductive element **12** and substrate **10**. Interlevel dielectric layer **14** is typically formed from two or more layers of materials, such as a thin conformal deposited oxide layer followed by a planarizing layer of reflow glass or spin on glass as known in the art. For purposes of the present invention, the precise constitution of the interlevel dielectric layer **14** is not important, so long as the etching properties of the materials used are known.

A hard masking layer **16** is formed over the interlevel dielectric layer **14**, typically to a thickness to 200 to 800 angstroms. The hard mask layer **16** is preferably formed from materials, such as titanium nitride or tantalum disilicide, which are highly selectively etchable with respect to the oxides used for the interlevel dielectric layer. Other materials may be used so long as they possess the property of high etch selectivity over the interlevel dielectric layer.

A thin layer of photoresist **18** is then deposited over the hard masking layer **16**. The thickness of the photoresist layer **18** is preferably the minimum thickness which can be used to guarantee protection of the underlying hard masking layer **16** during etching of that layer **16**. For hard mask layer materials such as titanium nitride or tantalum disilicide and photoresist material such as aristoline, approximately 3000 to 4000 angstroms of photoresist material is generally sufficient. More photoresist material is required for larger hard mask layer **16** thicknesses, with less being required a for thinner hard mask layer **16**.

Referring to **Figure 2**, an opening **20** is patterned in the photoresist layer **18**. The hard mask layer **16** is then anisotropically etched using the photoresist layer **18** as a mask. The hard mask layer **16** is etched for a sufficient time to ensure that layer **16** is completely removed from within the opening **20**.

Referring to **Figure 3**, the interlevel dielectric layer **14** is etched using the hard masking layer **16** as a mask. The etch is continued for a time sufficient to expose the underlying conductive element **12** within the opening **20**. The remains of the photoresist layer **18** may be left behind during the etching of the interlevel dielectric layer **14**, or the resist layer **18** may be removed prior to etching the interlevel dielectric layer **14**.

Referring to **Figure 4**, a second layer of resist is spun onto the device as shown by the dotted line **22**. This resist layer is preferably applied to coat the device to a thickness of approximately 3000 to 4000 angstroms. The resist will tend to fill in the contact opening **20**, although a perfectly smooth upper surface is not required. The photoresist layer **22** is then isotropically or anisotropically etched back to expose the underlying hard masking layer **16**. This results in formation of a resist plug **24** in the bottom of opening **20**. This resist plus is used to protect the underlying conductive element **12** during later removal of the hard mask layer **16**. Hard mask layer **16** is then removed by an anisotropic or isotropic etch.

Referring to **Figure 5**, the hard masking layer **16** has been removed, followed by removal of the resist plug **24**. Since the silicided conductive element **12** is typically attacked by the same etch chemistries used to remove the hard masking layer **16**, the resist plug **24** is provided to protect such underlying conductive element **12**. Once the resist plug **24** has been removed from the opening **20**, the contact is ready for further processing.

Referring to **Figure 6**, a conductive interconnect layer **26** has been deposited over the device and extends into the opening **20** to make contact with the conductive element **12**. The interconnect **26** can be, for example, aluminum, a metallic multilayer, or a polycrystalline silicon layer.

In **Figure 3**, an anisotropic etch only was performed. As known in the art, it is sometimes desirable to perform a chemical isotropic etch for a short period of time prior to performing an anisotropic etch in order to provide sloped sidewalls **28** along the edges of the contact opening **20**. When such an isotropic etch is performed, the contact opening **20** has the resulting structure shown in **Figure 6**. If an isotropic etch only is performed, the sloped sidewalls **28** will not be present, with the sidewalls of the opening **20** extending vertically to the top of the interlevel dielectric layer **14**. Filling of the opening **20** with the resist plug **24** protects the underlying conductive element **12** during removal of the hard mask layer **16** using either technique.

Since the hard mask layer **16** is removed after etching the contact opening, which is allowed by the presence of the protective resist plug **24**, it is not necessary that the layer **16** be formed from an insulating material. This means that conductive materials such as titanium nitride or tantalum disilicide, over which interlevel dielectric oxides are highly selectively etchable, may be used as the hard mask layer. High etch selectivity means that the hard masking layer **16** may be relatively thin; relative thinness of hard masking layer **16** in turn means that the photoresist layer **18** may be relatively thin. As described above, this provides for the highest obtainable resolution for a given set of photolithographic equipment, etch chemistries, and resist materials.

Thus, the described technique provides a means for obtaining improved resolution with a given set of materials and equipment. Of course, improving either the various chemistries or the photolithographic equipment will yield further resolution improvement in conjunction with the described method. The described technique is compatible with process flows generally used in the industry, and is relatively simple.

While the invention has been particularly shown and described with reference to a preferred embodiment, it will be understood by those skilled in the art that various changes in form and detail may be made therein without departing from the spirit and scope of the invention.

## Claims

1. A method for forming a contact for an integrated circuit device, comprising the steps of:

    forming a dielectric layer over a conductive element;

    forming a hard masking layer over the dielectric layer;

    forming a relatively thin layer of photoresist over the hard masking layer, wherein the photoresist layer has a thickness sufficient to mask the hard mask layer;

    etching an opening through the hard mask layer using the photoresist as a mask;

    etching a via through the dielectric layer to expose a portion of the conductive element using the hard masking layer as a mask;

    at least partially filling the via with a protective plug; and

    removing the hard masking layer, wherein the protective plug protects the exposed conductive element portion.

2. The method of Claim 1, further comprising the steps of:

    removing the protective plug; and

    forming a conductive interconnect layer over portions of the dielectric layer and extending into the via to contact the conductive element.

3. The method of Claim 1, wherein said step of etching a via through the dielectric layer comprises anisotropically etching the dielectric layer.

4. The method of Claim 1, wherein said step of etching a via through the dielectric layer comprises the steps of:

    isotropically etching partway through the dielectric layer to provide sloped sidewalls; and

    anisotropically etching the remainder of the way through the dielectric layer to expose the conductive element.

5. The method of Claim 1, wherein the conductive element comprises polycrystalline silicon.

6. The method of Claim 5, wherein the conductive element further includes a refractory metal silicide to improve conductivity.

7. The method of Claim 1, wherein said step of forming a dielectric layer comprises the step of:

    forming a planarizing layer including oxide over the conductive element.

8. The method of Claim 7, wherein said planarizing layer forming step includes the step of forming a layer of spin on glass.

9. The method of Claim 7, wherein said planarizing layer forming step includes the step of forming a layer of reflow glass.

10. The method of Claim 1, wherein the protective plug comprises photoresist.

11. The method of Claim 10, wherein said step of at least partially filling the via comprises the steps of:

    forming a layer of photoresist over the hard masking layer and filling the via; and

    etching back the photoresist layer to expose the hard masking layer, wherein a plug remains behind in the via.

12. The method of Claim 1, wherein said step of forming a hard masking layer comprises the step of:

    depositing a conductive layer containing a refractory metal over the dielectric layer.

13. A method for forming a contact for an integrated circuit device, comprising the steps of:

    forming a planarizing oxide layer over a conductive element;

    forming a hard masking layer containing a refractory metal over the oxide layer;

    forming a thin layer of photoresist over the hard masking layer;

    patterning the photoresist layer to define an opening over the conductive element;

    etching the hard masking layer using the photoresist layer as a mask;

    etching a via through the oxide layer to expose a portion of the conductive element using the oxide layer as a mask;

    forming a protective plug of photoresist in the via;

    removing the hard masking layer, wherein the plug protects the underlying conductive element;

    removing the protective plug; and

    forming a conductive interconnect layer over the oxide layer and contacting the conductive element.

14. The method of Claim 12 or 13, wherein the hard masking layer comprises titanium nitride.

15. The method of Claim 12 or 13, wherein the hard masking layer comprises tantalum silicide.

16. The method of Claim 13, wherein said step of etching a via comprises the steps of:

    isotropically etching partway through the oxide layer using the hard masking layer as a mask to form sloped sidewalls; and

    anisotropically etching the remainder of the way through the oxide layer to expose the conductive element.

FIG. 1

FIG. 2

FIG. 3

FIG. 4

FIG. 5

FIG. 6

EP 0 554 123 A1

European Patent
Office

**EUROPEAN SEARCH REPORT**

Application Number

EP    93 30 0699

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-2 206 540 (BRITISH AEROSPACE PUBLIC LTD CO.) <br> * page 3, paragraph 1 -paragraph 4 * <br> --- | 1-2, 10-12 | H01L21/90 <br> H01L21/311 |
| A | EP-A-0 416 809 (ATT CO.) <br> * column 2, line 22 - line 47 * <br> * column 3, line 55 - column 4, line 53 * <br> --- | 1,15 | |
| A | EP-A-0 405 256 (SGS-THOMSON MICROELECTRONICS  S.P.A.) <br> * claim 1; figure 3 * <br> ----- | 3-4,16 | |

TECHNICAL FIELDS
SEARCHED (Int. Cl.5)

H01L

The present search report has been drawn up for all claims

| Place of search | Date of completion of the search | Examiner |
|---|---|---|
| THE HAGUE | 11 MAY 1993 | SCHUERMANS N.F. |

EPO FORM 1503 03.82 (P0401)